# EUROPÄISCHE PATENTSCHRIFT

(11) **EP 0 931 346 B1**
(45) Veröffentlichungstag und Bekanntmachung des Hinweises auf die Patenterteilung: **10.02.2010**
(21) Anmeldenummer: 97912014.4
(22) Anmeldetag: 24.09.1997
(51) Int. Cl.: H01L 25/07, H01L 23/498

(54) **MIKROELEKTRONISCHES BAUTEIL IN SANDWICH-BAUWEISE**
MICROELECTRONIC COMPONENT WITH A SANDWICH DESIGN
COMPOSANT MICROELECTRONIQUE A STRUCTURE SANDWICH

(30) Priorität: 30.09.1996 DE 19640445
(43) Veröffentlichungstag der Anmeldung: 28.07.1999
(73) Patentinhaber: Infineon Technologies AG, 81669 München (DE)
(72) Erfinder: BRUCKMANN, Manfred, D-90475 Nürnberg (DE); KAINDL, Michael, D-81739 München (DE); LORENZ, Leo, D-85579 Neubiberg (DE); MÜNZING, Gerhard, Wilmslow SK9 2RB (GB); SCHWARZBAUER, Herbert, D-81373 München (DE); STERN, Peter, D-81476 München (DE)
(74) Vertreter: Bickel, Michael
(86) Internationale Anmeldenummer: PCT/DE1997/002169
(87) Internationale Veröffentlichungsnummer: WO 1998/015005

(56) Entgegenhaltungen:
- DE-A- 3 406 528
- JP-A- 08 203 961
- US-A- 4 855 867
- US-A- 4 922 376
- US-A- 5 155 661
- US-A- 5 203 075

## Beschreibung

Die Erfindung betrifft ein mikroelektronisches Bauteil in Sandwich-Bauweise, ein Verfahren zu dessen Herstellung sowie einen Wechselrichter, der das erfindungsgemäße mikroelektronische Bauteil enthält.

Derartige Wechselrichter können dazu verwendet werden, Gleichstrom in Drehstrom umzuwandeln, und werden beispielsweise bei der Steuerung von Motoren benötigt. Leistungsmodule, wie sie bislang in Wechselrichtern eingesetzt wurden, bestehen in der Regel aus einem Träger, auf welchem eine Anzahl von Leistungschips sowie Bauteile für Ansteuerung, Auswertung und Schutz o.ä. nebeneinander angeordnet sind. Der Träger kann beispielsweise eine Folie aus gefülltem Kunststoff sein, die auf einer Bodenplatte aus Aluminium angeordnet ist. Auf der Kunststoffolie befindet sich ein Leiterbahnsystem, üblicherweise aus Kupfer. Die Verbindung zwischen den einzelnen Bauteilen untereinander und zu den Leiterbahnen erfolgt durch die sogenannte Dickdrahtbondung. Bei den sogenannten Econopacks wird nicht auf die Leiterbahnen, sondern direkt auf die Anschlußpins gebondet. Sowohl bei den Econopacks als auch bei den Standard-Modulen werden zum Bonden jedoch Anschlußpins benötigt, deren Herstellung aufwendig und teuer ist, da sie in einem gesonderten Herstellungsschritt mit Spezialwerkzeugen gefertigt werden müssen.

Dadurch, daß alle Systemkomponenten in einer Ebene nebeneinander angeordnet sind, sind die bekannten Leistungsmodule relativ groß und die durch Bonddrähte zu überbrückenden Verbindungswege relativ lang. Ein niederinduktiver Aufbau ist bei einer derartigen Anordnung nur schlecht und mit sehr aufwendiger Technik zu realisieren. Um eine dynamische Gegenkopplung zu verhindern, ist für den Steueranschluß eine zusätzliche Steuersource nötig. Die Dickdrahtverbondung ist zudem hinsichtlich der Lastwechselbeanspruchungen eine Schwachstelle, was die Zuverlässigkeit der Leistungsmodule angeht.

Aus dem Stand der Technik ist aus DE 34 06 528 bekannt, während des Verlötens von Bauteilen mit Leiterbahnen eine Fixierung der Bauteile vorzusehen. Nach dem Verlöten sollen die Bauteile möglichst fest mit den Leiterbahnen verbunden bleiben. Zum Ausgleich möglicher mechanischer Spannungen können gegebenenfalls Ausgleichsstücke aus Molybdän vorgesehen werden.

US 4,922,376 offenbart die Verwendung von Federelementen bei Bauelementen zur Erzielung einer möglichst reparaturfreundlichen Kontaktierung von Bauelementen. Beim Versagen einer Kontaktierung kann deren Reparatur durch Lösen einer Schraubverbindung und Austausch des entsprechenden Federelementes erfolgen.

US 5,203,075 beschreibt ein Verfahren zur Verbindung eines ersten, flexiblen Leiterbahnsubstrats mit einem zweiten Leiterbahnsubstrats, wobei das erste Substrat leitfähige Kugeln aufweist, die mit Lötstellen auf dem zweiten Substrat verlötet werden.

US 4,855,867 zeigt ebenfalls ein flexibles Leiterbahnsubstrat, auf das Halbleiterchips montiert sind, die durch Kuglen elektrisch leitend mit einer festen Leiterplatte verbunden sind.

(JP 08-203961 A beschreibt bezugnehmend auf die englische Zusammenfassung (Patent Abstracts of Japan) eine mikroelektronische Anordnung mit einem Halbleiterchip 30, der Elektroden 31 aufweist, und mit einer Basis 40, die Elektroden 41 aufweist. Die Elektroden 31, 41 des Halbleiterchips 30 und der Basis 40 sind einander gegenüberliegend angeordnet und sind elektrisch leitend miteinander verbunden. Hierzu ist auf einer der Elektroden 31 ein Klebstoff aufgebracht, der mit einem elektrisch leitenden Material 51 überzogen ist. Dieses elektrisch leitfähige Material 51 ist mittels eines zweiten Klebstoffs an der zweiten Elektrode 41 befestigt.

**Aufgabe** der Erfindung ist es, ein mikroelektronisches Bauteil anzugeben, das insbesondere als Leistungsmodul verwendet werden kann und welches einfach und platzsparend aufgebaut ist, wobei eine Verbesserung bezüglich des Auftretens thermomechanischer Spannungen erzielt werden soll. Das mikroelektronische Bauteil sollte zudem kostengünstig und einfach herstellbar sein und eine hohe Flexibilität hinsichtlich der Anordnung der einzelnen Komponenten bieten. Weiterhin sollte ein niederinduktiver Aufbau des Leistungs- und Ansteuerteils gewährleistet sein.

Die Lösung der Aufgabe gelingt mit dem mikroelektronischen Bauteil gemäß Anspruch 1, welches gemäß dem Verfahren nach Anspruch 26 hergestellt und in einem Wechselrichter gemäß Anspruch 27, verwendet werden kann. Die Erfindung betrifft weiterhin einen mikroelektronischen Baustein gemäß Anspruch 22, welcher als Vorstufe des erfindungsgemäßen Bauteils eingesetzt werden kann. Weiterbildungen und bevorzugte Maßnahmen ergeben sich aus den Unteransprüchen.

Die Erfindung betrifft demgemäß ein mikroelektronisches Bauteil in Sandwich-Bauweise, welches einen ersten Träger mit einer ersten Leiterbahnebene und einen zweiten Träger mit einer zweiten Leiterbahnebene umfaßt. Zwischen beiden Trägern sind mehrere Halbleiterchips angeordnet, welche mit beiden Leiterbahnen kontaktiert sind. Die Kontaktierung der Halbleiterchips in dem erfindungsgemäßen Multichipmodul erfolgt von der dem ersten Träger abgewandten Oberfläche der Halbleiterchips zur zweiten Leiterbahnebene durch feste Kontaktierungen. Durch die Sandwich-Bauweise ist ein wesentlich kompakterer, platzsparenderer Aufbau möglich als bei Verwendung eines einzelnen Trägers. Die Flexibilität bei der Anordnung der Einzelkomponenten ist deutlich größer.

Unter fester Kontaktierung zwischen Halbleiterchips und Leiterbahnebene ist zu verstehen, daß die Kontaktierung nicht mit Hilfe von Bonddrähten erfolgt. Es werden vielmehr Kontaktierungen vorgesehen, die bezüglich thermomechanischen Spannungen unempflindlicher sind als Lötverbindungen. Geeignete Kontaktierungen sind nach Anspruch 1 solche mit Hilfe eines elektrisch leitfähigen, flexiblen Klebstoffs. Es können dabei alle leitfähigen Klebstoffe eingesetzt werden, die bei mikroelektronischen Bauteilen üblicherweise Verwendung finden.

Die Kontaktierung kann unter Verwendung elektrisch leitfähiger Kugeln erfolgen. Diese Kontaktierungstechnik ist grundsätzlich bekannt und wird im allgemeinen als "Ball Grid-Technik" bezeichnet. Die elektrisch leitfähigen Kugeln bestehen vorzugsweise aus einem metallischen Material wie Blei, einem Bleilot, Zinn, einem Zinn-Antimon-Lot, Kupfer oder anderen Metallen wie Silber oder deren Legierungen. Es ist dabei vorgesehen, die Kugeln mit Hilfe eines elektrisch leitfähigen, flexiblen Klebstoffs zu befestigen.

Nach dem erfindungsgemäßen Verfahren können die erfindungsgemäßen mikroelektronischen Bauteile dadurch hergestellt werden, daß man die elektrisch leitfähigen Kugeln zunächst auf die Kontaktstellen der zweiten Leiterbahnebene aufbringt. Die leitfähigen Kugeln können vorzugsweise durch eine Lochblende aufgebracht werden. Überschüssige Kugeln werden entfernt. Besonders vorteilhaft ist es, wenn die Kugeln einen geringen Abstand voneinander einhalten. Im letzten Verfahrensschritt werden erster und zweiter Träger mit den auf ihnen angebrachten Chips und elektrisch leitfähigen Kugeln zusammengefügt, so daß Chips und zweite Leiterbahnebene kontaktiert werden.

Alternativ ist es möglich, die elektrisch leitfähigen Kugeln auf der Oberfläche des Halbleiterchips aufzubringen.

Nach Fertigstellung der erfindungsgemäßen Sandwich-Strukturen werden die Zwischenräume zwischen erstem und zweitem Träger und gegebenenfalls zwischen weiteren Trägerebenen bevorzugt mit einem dielektrischen Material ausgefüllt. Geeignet ist z.B. Silikonharz beziehungsweise -gel.

Die Halbleiterchips, die im erfindungsgemäßen mikroelektronischen Bauteil verwendet werden, können grundsätzlich auf jede beliebige Weise auf dem ersten Träger befestigt und mit der ersten Leiterbahnebene kontaktiert sein. Vorzugsweise sind die Halbleiterchips auf den ersten Träger aufgelötet und besonders bevorzugt in gleicher Weise mit erstem Träger und erster Leiterbahnebene verbunden wie mit zweitem Träger und zweiter Leiterbahnebene. In diesem Fall werden Halbleiterchips mit beidseitig lötbaren Oberflächen benötigt. Derartige Chips sind grundsätzlich bekannt. Beispielsweise können ihre Oberflächen mit einer Nickel-Gold-Schicht versehen sein, die das Aufbringen von Lot erlaubt.

Als Träger eignen sich die verschiedenen Trägermaterialien, die üblicherweise für mikroelektronische Bauteile verwendet werden, also beispielsweise Kunststoffolien oder -laminate, gegebenenfalls im Verbund mit anderen Materialien. Besonders geeignet sind keramische Materialien, z.B. solche aus Aluminiumoxid- oder Aluminiumnitrid-Keramik. Im Verbund mit einer entsprechenden Leiterbahnebene sind solche keramischen Träger z.B. als Dickschichtkeramik bekannt, bei der das Leiterbahnsystem, das aus Kupfer, Silber oder ähnlichem bestehen kann, auf den Träger auf- oder eingebrannt ist. Weitere geeignete Verbundsysteme aus Träger und Leiterbahnen sind solche, die in DCB (Direct Copper Bonding)- oder AMB (Active Metal Brazing)- Technik ausgeführt sind. Derartige Keramikträger weisen eine erheblich bessere Wärmeleitfähigkeit auf als Kunststoffträger, was sie insbesondere für Leistungsmodule besonders geeignet macht.

Zur Verbesserung der Wärmeableitung kann zusätzlich auf der der Leiterbahnebene gegenüberliegenden Seite des ersten und/oder zweiten Trägers eine Metallschicht angebracht sein, die beispielsweise aus Kupfer besteht. Eine derartige Metallschicht dient als Wärmespreizer und kann mit einer Wärmesenke (z.B. einer Metallplatte) gekoppelt werden, um die Wärmeabfuhr weiter zu verbessern.

Eine gute Ableitung ist insbesondere dann erforderlich, wenn das erfindungsgemäße mikroelektronische Bauteil gemäß einer bevorzugten Ausführungsform mit Leistungschips bestückt ist. Werden diese Chips ständigen Lastwechseln ausgesetzt, erwärmen und kühlen sie sich im Wechsel ab. Dies führt unter Umständen dazu, daß das erfindungsgemäße Sandwich-System arbeitet und die Verbindungen zwischen Halbleiterchips und Leiterbahnebene(n) mechanisch erheblich beansprucht werden. Diese Beanspruchung ist bei Verwendung elektrisch leitfähiger Klebstoffe weniger kritisch als bei reinen Lötverbindungen und insbesondere bei Lötverbindungen unter Verwendung der elektrisch leitfähigen Kugeln.

Nach einer Variante wird der zweite Träger in mehrere, gegeneinander bewegliche Einzelbereiche zertrennt, die den durch die Temperaturänderung verursachten Bewegungen im System folgen können.

In einer bevorzugten Ausführungsform der Erfindung wird der zweite Träger insgesamt aus einem flexiblen Material gefertigt. Besonders geeignet ist ein Träger aus Kunststoffolie, vorzugsweise Polyimidfolie.

Wird als zweiter Träger eine flexible Folie verwendet, werden auf dieser vorzugsweise keine weiteren Bauteile angeordnet, obgleich auch dieses möglich ist. Vorteilhafter ist es, die weiteren Bauteile um den erfindungsgemäßen Sandwich-Modul herum anzuordnen. Dennoch erfordert dies keine zusätzlichen Anschlußpins im erfindungsgemäßen Sandwich-Modul, da die Kontaktierung direkt auf die Leiterbahn erfolgen kann, die auf der flexiblen Trägerfolie angeordnet ist. Hierzu muß die Folie lediglich an den Rändern etwas aufgebogen werden.

Die erfindungsgemäßen mikroelektronischen Bauteile erlauben durch ihre Sandwich-Bauweise eine vielfältige Gestaltung hinsichtlich der Anordnung der einzelnen verwendeten Komponenten.
Neben den Halbleiterchips können die mikroelektronischen Bauteile beispielsweise Ansteuer- und/oder Auswerteelektronik-und/oder Schutzbauteile enthalten, wie sie üblicherweise in mikroelektronischen Bauteilen verwendet werden. Beispielhaft können Impulsgenerierer, Impulsübertrager, Pulsbreitenmodulatoren, Kontroller, Optokoppler und dergleichen genannt werden. Weitere mögliche Bauteile sind z.B. Chopper und Ausgangswechselrichter.

Diese Bauteile können entweder alle auf dem ersten Träger oder teilweise auf dem ersten und zweiten Träger und gegebenenfalls auf weiteren Trägern angeordnet sein, wenn das erfindungsgemäße mikroelektronische Bauteil mehr als zwei übereinanderliegende Trägerschichten umfaßt. Die Anordnung von Bauteilen auf mehreren Ebenen hat den Vorteil, daß das erfindungsgemäße mikroelektronische Bauteil besonders kompakt ausgestaltet werden kann. Zudem können Ansteuer-, Schutz- oder Auswerteelektronik direkt über dem jeweils zugehörigen Halbleiter-Bauelement positioniert werden, wodurch ein sehr übersichtlicher und zweckmäßiger Aufbau erreichbar ist. Die Kontaktierung erfolgt in einem solchen Fall bevorzugt über Vialöcher, die im zweiten Träger angebracht sind.

Wie erwähnt, ist das erfindungsgemäße Bauteil jedoch nicht auf nur zwei übereinander angeordnete Träger beschränkt. Es können vielmehr weitere Ebenen im mikroelektronischen Bauteil vorhanden sein.

Bei Verwendung von keramischen Trägern und insbesondere von Dickschichtkeramik ist es außerdem möglich, den Logikteil, also beispielsweise Controller-ICs, PWM-ICs (IC = Integrated Circuit, PWM = Pulse Width Modulation), in einer Ebene mit den Leistungschips anzuordnen. Hierbei wird zweckmäßig eine integrierte Abschirmung, beispielsweise in Form von metallischen Schichten auf erstem und zweitem Träger, im erfindungsgemäßen mikroelektronischen Bauteil vorgesehen, welche den Logikteil im Hinblick auf die elektromagnetische Verträglichkeit (EMV) schützt.

Eine besonders bevorzugte Ausführungsform des erfindungsgemäßen mikroelektronischen Bauteils umfaßt zwei Schalttransistoren, vorzugsweise IGBTs (Isolated Gate Bipolar Transistor), und zwei Dioden und kann beispielsweise bei der Umwandlung von Gleichstrom in Drehstrom verwendet werden. Ein Wechselrichter, welcher ein erfindungsgemäßes mikroelektronisches Bauteil enthält, ist ebenfalls Gegenstand der Erfindung.

Im Wechselrichterbetrieb wird je nach Belastungsart entweder der Schalttransistor oder die Diode heißer und somit treten thermomechanische Spannungen im mikroelektronischen Bauteil auf. Derartige Spannungen können dazu führen, daß die Kontaktierungen zwischen erster und zweiter Leiterbahnebene zerstört werden. Dieses Problem tritt ganz allgemein bei solchen mikroelektronischen Bauteilen auf, welche Leistungschips verwenden, wie dies bereits vorstehend beschrieben wurde. Zur Vermeidung dieses Problems wird das erfindungsgemäße mikroelektronische Bauteil vorzugsweise so ausgebildet, daß die Kontaktierung der Halbleiterchips mit der zweiten Leiterbahnebene und gegebenenfalls auch der ersten Leiterbahnebene mit Hilfe elektrisch leitfähiger Federelemente ausgeführt wird.

Im allgemeinen wird zum Auffangen der thermomechanischen Spannungen bereits die Kontaktierung der Halbleiterchips mit der zweiten Leiterbahnebene durch elektrisch leitfähige Federelemente ausreichen. Die Federelemente werden an Halbleiterchip-Oberfläche und Leiterbahnebenen vorzugsweise mit Hilfe eines elektrisch leitfähigen Klebstoffs angeklebt oder, besonders bei hoher Leistungsaufnahme, angelötet.

In einer bevorzugten Ausführungsform sind die Federelemente als eng gewickelte Spiralfedern mit ringförmig geschlossenen Enden ausgebildet. Bei einer derartigen Ausgestaltung können sich die einzelnen Federn nicht ineinander verhaken, und so ist es möglich, die für ein erfindungsgemäßes mikroelektronisches Bauteil benötigten Federelemente in einem einzigen Arbeitsschritt in eine geeignete Lötform einzurütteln und dann an die Halbleiterchips oder die Leiterbahnebene anzulöten.

Die Länge der Federelemente wird zweckmäßig so gewählt, daß Dickenabweichungen zwischen den verschiedenen Chips in einem erfindungsgemäßen Bauteil sowie Abstandsänderungen aufgrund thermomechanischer Spannungen zwischen erstem und zweitem Träger ausgeglichen werden können. Besonders bevorzugt sind die Federelemente so lang, daß die Kontaktierungen zwischen erstem und zweitem Träger ohne zusätzlich eingefügte Kontaktblöcke ausgeführt werden können.

In einer Variante des erfindungsgemäßen mikroelektronischen Bauteils wird ein Ende des Federelements an den Halbleiterchip gelötet und das andere Ende auf die Leiterbahnebene, welche auf dem zweiten Träger angeordnet ist. Hierfür können auf die Kontaktstellen der Leiterbahnebene auf die bereits beschriebene Weise, z.B. durch Aufdrucken, Lötpads aufgebracht werden.

In einer anderen Variante sind die den Halbleiterchips abgewandten Enden der Federelemente in Ausnehmungen oder Durchgangsöffnungen im zweiten Träger eingeklebt oder vorzugsweise eingelötet. Bei dieser Variante werden die Federelemente also in der Regel länger sein als in der ersten Variante, bei denen die Lötpads auf der Oberfläche des zweiten Trägers enden. Die Federelemente sind also zweckmäßig so lang, daß eine ausreichende Kontaktierung und eine hinreichend sichere Befestigung in den Ausnehmungen oder Durchgangsöffnungen des zweiten Trägers auch unter Einfluß thermomechanischer Spannungen gewährleistet ist.

Zusätzlich zu den Federelementen, welche Halbleiterchips und zweite Leiterbahnebene verbinden, können weitere Federelemente zwischen erster und zweiter Leiterbahnebene oder erstem und zweitem Träger angeordnet sein. Auch diese zusätzlichen Federelemente können beispielsweise mit Hilfe eines elektrisch leitfähigen Klebstoffes angeklebt oder angelötet sein. Greifen die Federelemente in Ausnehmungen oder Durchgangsöffnungen des zweiten Trägers ein, ist eine bevorzugte Befestigungsart für die Federelemente das Schwall-Löten.

Grundsätzlich können einzelne oder alle der vorstehend beschriebenen Kontaktierungs- und Befestigungsarten auch in einem mikroelektronischen Bauteil miteinander kombiniert sein.

Um eine stabile und einfache Befestigung zwischen erstem und zweitem Träger zu gewährleisten, werden beide Träger vorzugsweise miteinander verklammert. Hierzu sind zweckmäßig an einem der beiden Träger zwei oder mehr Halterungen vorgesehen, welche lösbar in zugehörige Ausnehmungen oder Durchgangsöffnungen im anderen Träger eingreifen. Um einen sicheren Halt zu gewährleisten, können die Halterungen an ihren Enden hierzu mit Schnappnasen oder sonstigen widerhakenähnlichen Vorrichtungen versehen sein, welche ein Herausrutschen aus den Ausnehmungen oder Durchgangsöffnungen verhindern. Die beschriebenen Maßnahmen können entsprechend auf weitere Ebenen angewendet werden, wenn diese im mikroelektronischen Bauteil vorhanden sind.

Für die genannte Art der Befestigung von erstem und zweitem Träger besonders geeignet ist ein mikroelektronischer Baustein, welcher eine Vorstufe des mikroelektronischen Bauteils gemäß dieser Erfindung darstellt und welcher ebenfalls Gegenstand dieser Erfindung ist. Der erfindungsgemäße mikroelektronische Baustein umfaßt einen ersten Träger mit einer ersten Leiterbahnebene und einer Vielzahl von Halbleiterchips, welche mit der ersten Leiterbahnebene kontaktiert sind. Zur Kontaktierung der Halbleiterchips mit einer weiteren Leiterbahnebene sind auf die vorstehend beschriebene Weise auf den Halbleiterchips elektrisch leitfähige Federelemente oder elektrisch leitfähige Kugeln angebracht. In einer bevorzugten Weiterbildung umfaßt der mikroelektronische Baustein Halterungen zum Verklammern des mikroelektronischen Bausteins mit dem zweiten Träger, welcher die beschriebenen Ausnehmungen oder Durchgangsöffnungen zur Aufnahme der Halterungen aufweist.

Der mikroelektronische Baustein kann weiterhin eine Metallbeschichtung als Wärmespreizer und/oder eine Wärmesenke zur Abfuhr der durch die Halbleiterchips erzeugten Wärme umfassen. Darüber hinaus können die Halbleiterchips und die umliegende Oberfläche des ersten Trägers mit einer dielektrischen Masse abgedeckt sein, beispielsweise Silikonharz oder -Gel, wie dies ebenfalls bereits beschrieben wurde. Die Dicke der aufgetragenen dielektrischen Masse ist vorzugsweise so, daß im fertigen mikroelektronischen Bauteil der Zwischenraum zwischen erstem und zweitem Träger möglichst vollständig ausgefüllt ist.

Der erfindungsgemäße mikroelektronische Baustein ist vorzugsweise soweit vorgefertigt, daß er beim Endabnehmer nur noch mit einem geeigneten zweiten Träger zusammengeklammert werden muß und beim Endabnehmer dann die Kontaktierungen zum zweiten Träger ausgeführt werden.

Die Erfindung soll im folgenden anhand einer Zeichnung näher erläutert werden. Dabei zeigen
- Figur 1: schematisch einen Querschnitt durch ein er- findungsgemäßes mikroelektronisches Bauteil,
- Figur 2: schematisch einen Querschnitt durch einen Teilbereich des erfindungsgemäßen Bauteils,
- Figur 3: einen Querschnitt durch einen Teilbereich eines Lotblöcke aufweisenden Bauteils,
- Figur 4: schematisch ein erfindungsgemäßes mikroelektronisches Bauteil in Explosionsdarstellung.

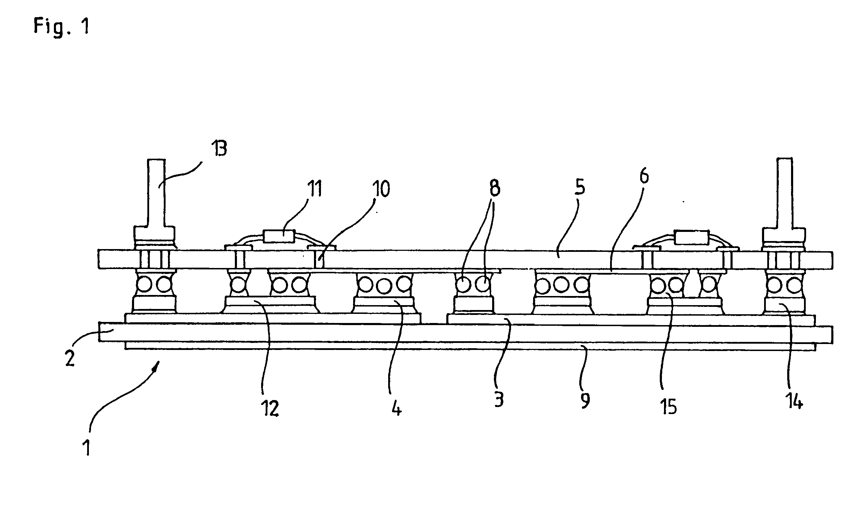

Im einzelnen zeigt Figur 1 schematisch ein erfindungsgemäßes mikroelektronisches Bauteil 1 mit einem ersten Träger 2 und einem zweiten Träger 5, auf welchen eine erste Leiterbahnebene 3 beziehungsweise eine zweite Leiterbahnebene 6 angeordnet sind. Der Verbund aus Träger und zugehöriger Leiterbahnebene (2,3 beziehungsweise 5,6) besteht beispielsweise aus Dickschichtkeramik oder ist in DCB (Direct Copper Bonding)-Technik ausgeführt. Auf der der ersten Leiterbahnebene 3 gegenüberliegenden Seite des ersten Trägers 2 ist eine Metallschicht 9 angebracht, die beispielsweise aus Kupfer bestehen kann und als Wärmespreizer dient. Die Metallschicht 9 kann zum Beispiel mit einem wärmeleitfähigen Klebstoff an eine Wärmesenke geklebt werden und sorgt für eine bessere Abfuhr der im Bauteil erzeugten Wärme.

Zwischen erster und zweiter Leiterbahnebene sind mehrere Halbleiterchips 4 angeordnet, im gezeigten Fall zwei Dioden und zwei Schalttransistoren 12 , welche auf die erste Leiterbahnebene 3 gelötet oder auf sonstige übliche Weise an ihr befestigt sein können. Die Schalttransistoren 12 sind vorzugsweise IGBTs (Isolated Gate Bipolar Transistors). Die Kontaktierung der Halbleiterchips 4 zur zweiten Leiterbahnebene 6 ist mit Hilfe der sogenannten Ball Grid-Technik ausgeführt. Die hierbei verwendeten elektrisch leitfähigen Kugeln 8 sind in Lotmasse 15 eingebettet, welche entsprechend der Lage der Kontaktstellen auf der Oberfläche der Halbleiterchips 4 aufgetragen ist. Austelle der Lotmasse Kann auch ein elektrisch leitfähigen Kleber verwendet wer den. Die Kugeln 8 bestehen zweckmäßig aus einem metallischen Material wie zum Beispiel Blei oder Kupfer und insbesondere aus einer Lotmasse, wie sie üblicherweise im Zusammenhang mit mikroelektronischen Bauteilen verwendet wird.

Über den Schalttransistoren 12 sind auf der der zweiten Leiterbahnebene 6 gegenüberliegenden Seite des zweiten Trägers 5 zwei SMD (Surface Mount Device)-Bausteine 11 angeordnet, welche Ansteuer- und Auswerteelektronik umfassen. Sie sind über Vialöcher 10 mit der zweiten Leiterbahnebene 6 kontaktiert. Diese Anordnung verdeutlicht einige der Vorteile des erfindungsgemäßen mikroelektronischen Bauteils, nämlich den durch die Sandwich-Bauweise ermöglichten kompakten Aufbau, die Anordnung zusammengehöriger Bauteile in unmittelbarer Nähe zueinander und die Möglichkeit, Kontaktierungen ohne Bonddrähte durchzuführen.

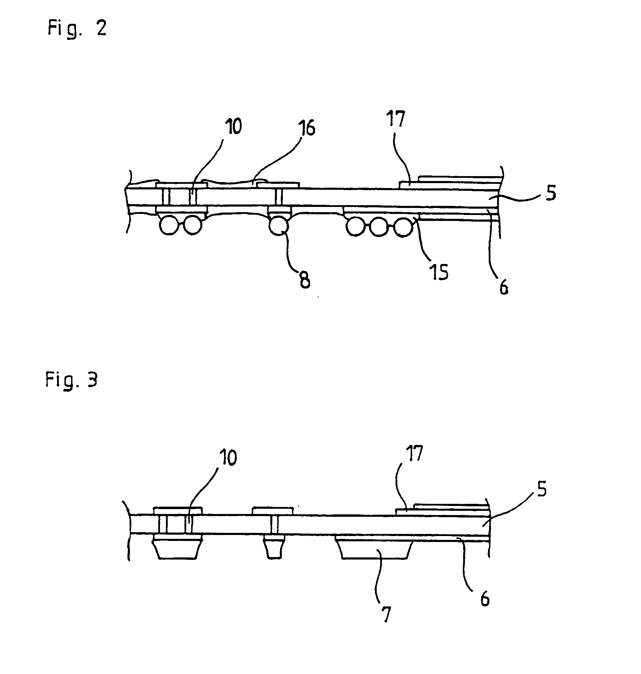

Die gezeigte Anordnung kann beispielsweise zur Erzeugung von Drehstrom aus Gleichstrom dienen. Die Stromzufuhr erfolgt dabei über die Lastanschlüsse 13. Die Durchkontaktierung zwischen erster und zweiter Leiterbahnebene im Bereich der Lastanschlüsse 13 ist in diesem Fall durch Aufbringen einer Ball Grid-Verbindung auf eine leitfähige Überbrückung 14 erreicht. Zur Überbrückung kann zum Beispiel ein Metallblock, etwa aus Kupfer, dienen. Figuren 2 und 3 verdeutlichen zwei unterschiedliche Möglichkeiten der Kontaktierung von zweiter Leiterbahnebene 6 und Halbleiterchips 4. Figur 2 erläutert die Ball Grid-Technik, die bereits in Figur 1 dargestellt ist. Gezeigt in ein Teilbereich eines erfindungsgemäßen mikroelektronischen Bauteils, nämlich ein Ausschnitt eines zweiten Trägers 5 mit zweiter Leiterbahnebene 6. Der zweite Träger kann erneut aus Dickschichtkeramik bestehen oder vom DCB-Typ sein. Entsprechend der Lage der zu kontaktierenden Kontaktflächen der Halbleiterchips 4 sind auf der zweiten Leiterbahnebene 6 der Klebstoff 15 und elektrisch leitfähige Kugeln 8 angeordnet. Auf der der zweiten Leiterbahnebene 6 gegenüberliegenden Seite des zweiten Trägers 5 befindet sich eine weitere Leiterbahnebene 17 zur Kontaktierung von SMD-Bauteilen. Zur Kontaktierung mit der zweiten Leiterbahnebene 6 weist der Träger 5 Vialöcher 10 auf.

Figur 3 zeigt eine Möglichkeit der Kontaktierung bei der anstelle der elektrisch leitfähigen Kugeln 8 hier Lotblöcke 7 zur Kontaktierung der Halbleiterchips verwendet werden. Die Lotblöcke können aus üblicherweise zum Löten in mikroelektronischen Bauteilen eingesetzten Materialien bestehen. Vorzugsweise werden relativ hochschmelzende Lote verwendet. Gegenüber den Ball Grid-Verbindungen, die in Figur 2 dargestellt sind, führen die Lotblöcke 7 zu etwas festeren Kontaktverbindungen, die mehr mechanische Arbeit aufnehmen können.

Eine weitere Kontaktierungsmöglichkeit ist die Kontaktierung durch Federelemente. Diese Federelemente können beispielsweise als sehr eng gewickelte Spiralfedern ausgebildet sein, deren beide Enden vorzugsweise ringförmig geschlossen sind, so daß sich die einzelnen Spiralfedern nicht ineinander verhaken können. Dies ermöglicht es, alle Spiralfedern, die auf der ersten Leiterbahnebene plaziert werden sollen, in einem einzigen Arbeitsschritt mit Hilfe einer Schablone zu positionieren, welche beispielsweise entsprechend den späteren Befestigungspositionen Durchgangsöffnungen geeigneter Größe aufweist, in welche die Federelemente zum Beispiel eingerüttelt und über dem ersten Träger aufgebracht werden können. Die Federelemente können sowohl auf die Oberflächen der Halbleiterchips 4 als auch auf die erste Leiterbahnebene auf dem ersten Träger 2 angelötet. Nach dem Anlöten der Federelemente wird die Oberfläche des ersten Trägers 2 mit einer Schicht aus dielektrischen Material, hier Silikonharz, abgedeckt.

Das erfindungsgemäße mikroelektronische Bauteil besteht dabei aus zwei Bestandteilen, nämlich einem vorgefertigten mikroelektronischen Baustein, der neben den bereits beschriebenen Komponenten eine Wärmesenke umfaßt, die auf der den Halbleiterchips 4 gegenüberliegenden Seite des ersten Trägers 2 angebracht ist, sowie Halterungen, welche an den Seiten des mikroelektronischen Bausteins in Richtung auf den zweiten Träger 5 vorstehen. Die Halterungen greifen in Durchgangsöffnungen in den zweiten Träger 5 ein, wobei die Schnappnasen an den Enden der Halterungen über den zweiten Träger 5 vorstehen und ein Herausrutschen des einmal befestigten mikroelektronischen Bausteins aus dem zweiten Träger verhindern. Nach dem Verklammern des mikroelektronischen Bausteins mit dem zweiten Träger 5 müssen nur noch die elektrischen Kontakte zwischen den Federelementen und der zweiten Leiterbahnebene, auf dem zweiten Träger 5 durchgeführt werden. In beiden Fällen erfolgt die Kontaktierung durch einen Lötprozeß.

In einer ersten Ausführungsform sind zu diesem Zweck auf der Leiterbahnebene des zweiten Trägers 5 an den entsprechenden Kontaktstellen Lotpads angebracht. Vorzugsweise werden diese Lotpads durch Siebdruck erzeugt. Die Kontaktierung erfolgt nach dem Zusammenstecken der Bausteine durch ein herkömmliches Lötverfahren.

Die Kontaktierung erfolgt bei einer zweiten Anordnung nach der Durchstecktechnik (THT). Hierzu sind im zweiten Träger 5 Durchgangsöffnungen vorgesehen, deren Größe und Position sich nach den Federelementen auf dem mikroelektronischen Baustein richtet. Beim Zusammenstecken von mikroelektronischem Baustein und zweitem Träger 5 kommen die Federelemente in den Durchgangsöffnungen zu liegen. Die Kontaktierung erfolgt vorzugsweise durch Schwall-Löten auf an sich bekannte Weise.

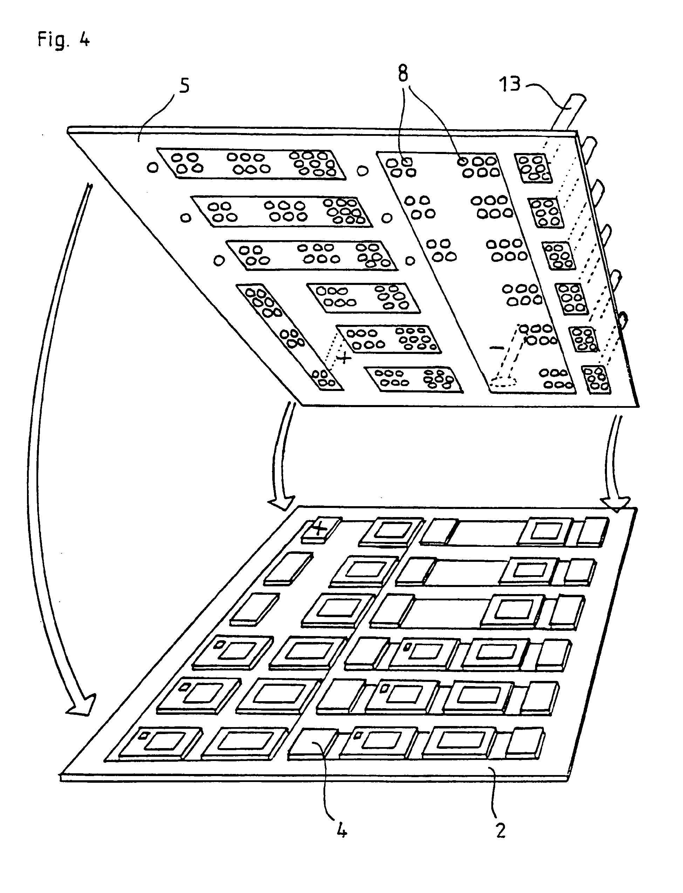

Figur 4 zeigt ein erfindungsgemäßes mikroelektronisches Bauteil in Explosionsdarstellung und verdeutlicht gleichzeitig das erfindungsgemäße Verfahren. Im oberen Teil der Darstellung ist der zweite Träger 5 mit mehreren Anschlüssen 13 gezeigt. Auf dem zweiten Träger 5 sind - der Lage der Kontaktflächen der zu kontaktierenden Halbleiterchips 4 auf dem unten in der Figur abgebildeten ersten Träger 2 entsprechend - elektrisch leitfähige Kugeln 8 befestigt. Der hierzu verwendete Klebstoff ist nicht dargestellt. Ebensowenig ist der Klebstoff gezeigt, der auf die Kontaktflächen der Halbleiterchips 4 aufgetragen ist.
Zur Kontaktierung werden erster und zweiter Träger aufeinandergefügt. Dabei erfolgt die Ausbildung sämtlicher Kontakte zu den Halbleiterchips 4 in einem Arbeitsschritt.

Die erfindungsgemäßen mikroelektronischen Bauteile können ohne weiteres automatisch in Serie gefertigt werden. Verglichen mit der Kontaktierung durch Dickdrahtverbondung, wie sie im Stand der Technik üblich ist und bei der alle Bonddrahtverbindungen einzeln ausgeführt werden müssen, ist eine erhebliche Zeitersparnis möglich. Ein weiterer Vorteil besteht darin, daß durch Vermeidung der Drahtbondung ein extrem niederinduktiver Aufbau möglich ist und eine höhere Zuverlässigkeit erreicht wird. Die aufwendige Fertigung von Anschlußpins für die Bondung entfällt. Außerdem ist durch die Sandwich-Bauweise ein sehr kompakter Aufbau bei größtmöglicher Flexibilität hinsichtlich der Anordnung weiterer Elektronikbauteile erreichbar.

## Patentansprüche

1. Mikroelektronisches Bauteil (1) in Sandwichbauweise, welches einen ersten Träger (2) mit einer ersten Leiterbahnebene (3) und einer Vielzahl von Halbleiterchips (4) umfaßt, welche mit der ersten Leiterbahnebene (3) kontaktiert sind, wobei auf der dem ersten Träger (2) gegenüberliegenden Seite der Halbleiterchips (4) ein zweiter Träger (5) mit einer zweiten Leiterbahnebene (6) angeordnet ist, welche mit den von dem ersten Träger (2) abgewandten Oberflächen der Halbleiterchips (4) fest kontaktiert ist,
**dadurch gekennzeichnet,**
**daß** eine bezüglich thermomechanischen Spannungen im Vergleich zu Lötverbindungen unempfindlichere Kontaktierung der Halbleiterchips (4) mit der zweiten Leiterbahnebene (6) vorgesehen ist, die mit Hilfe eines elektrisch leitfähigen, flexiblen Klebstoffs ausgeführt ist.

2. Mikroelektronisches Bauteil gemäß Anspruch 1,
**dadurch gekennzeichnet,**
**daß** elektrisch leitfähige Kugeln (8) an die Halbleiterchips (4) und die zweite Leiterbahnebene (6) mit Hilfe des elektrisch leitfähigen Klebstoffs angeklebt sind.

3. Mikroelektronisches Bauelement gemäß Anspruch 1,
**dadurch gekennzeichnet,**
**daß** elektrisch leitfähige Federelemente an die Halbleiterchips (4) und die zweite Leiterbahnebene (6) mit Hilfe eines elektrisch leitfähigen Klebstoffs angeklebt sind.

4. Mikroelektronisches Bauteil gemäß einem der Ansprüche 1 bis 3,
**dadurch gekennzeichnet,**
**daß** wenigstens einer der ersten und zweiten Träger (2, 5) aus einem keramischen Material besteht.

5. Mikroelektronisches Bauteil gemäß Anspruch 4,
**dadurch gekennzeichnet,**
**daß** das keramische Material aus Aluminiumoxid- oder Aluminiumnitrid-Keramik besteht.

6. Mikroelektronisches Bauteil gemäß Anspruch 4 oder 5,
**dadurch gekennzeichnet,**
**daß** der Verbund von Träger (2, 5) und Leiterbahn (3, 6) als Dickschichtkeramik mit auf- oder eingebrannten Leiterbahnen oder in Direct-Copper-Bonding-Technik oder Active-Metal-Brazing-Technik ausgeführt ist.

7. Mikroelektronisches Bauteil gemäß Anspruch 6,
**dadurch gekennzeichnet,**
**daß** die Leiterbahnen aus Kupfer oder Silber bestehen.

8. Mikroelektronisches Bauteil gemäß einem der Ansprüche 1 bis 7,
**dadurch gekennzeichnet,**
**daß** auf der der Leiterbahn gegenüberliegenden Seite wenigstens eines der ersten und zweiten Träger (2, 5) eine Metallschicht (9) ausgebildet ist.

9. Mikroelektronisches Bauteil gemäß einem der Ansprüche 1 bis 8,
**dadurch gekennzeichnet,**
**daß** auf der der Leiterbahn gegenüberliegenden Seite wenigstens eines der ersten und zweiten Träger (2, 5) eine Wärmesenke angeordnet ist.

10. Mikroelektronisches Bauteil gemäß einem der Ansprüche 1 bis 9,
**dadurch gekennzeichnet,**
**daß** der zweite Träger (5) Vialöcher (10) aufweist.

11. Mikroelektronisches Bauteil gemäß einem der Ansprüche 1 bis 10,
**dadurch gekennzeichnet,**
**daß** die Halbleiterchips (4) Leistungschips sind.

12. Mikroelektronisches Bauteil gemäß einem der Ansprüche 1 bis 11,
**dadurch gekennzeichnet,**
**daß** es weiter wenigstens ein Ansteuerbauteil, Auswerteelektronikbauteil, ein Schutzbauteil (11) umfaßt.

13. Mikroelektronisches Bauteil gemäß Anspruch 12,
**dadurch gekennzeichnet,**
**daß** wenigstens eines der Ansteuer- oder Auswerteelektronik-oder Schutzbauteile (11) auf dem zweiten Träger (5) angeordnet ist.

14. Mikroelektronisches Bauteil gemäß Anspruch 13,
**dadurch gekennzeichnet,**
**daß** das Bauteil (11) über Vialöcher (10) im zweiten Träger (5) mit der zweiten Leiterbahnebene (6) kontaktiert ist.

15. Mikroelektronisches Bauteil gemäß einem der Ansprüche 1 bis 14,
**dadurch gekennzeichnet,**
**daß** erster und zweiter Träger (2, 5) miteinander verklammert sind.

16. Mikroelektronisches Bauteil gemäß Anspruch 15,
**dadurch gekennzeichnet,**
**daß** an einem der Träger (2, 5) zwei oder mehr Halterungen vorhanden sind, welche lösbar in zugehörige Ausnehmungen oder Durchgangsöffnungen im anderen Träger (5,2) eingreifen.

17. Mikroelektronisches Bauteil gemäß einem der Ansprüche 1 bis 16,
**dadurch gekennzeichnet,**
**daß** der zweite Träger (5) in mehrere Einzelbereiche zertrennt ist.

18. Mikroelektronisches Bauteil gemäß einem der Ansprüche 1 bis 17,
**dadurch gekennzeichnet,**
**daß** der zweite Träger (5) ein flexibler Träger ist.

19. Mikroelektronisches Bauteil gemäß Anspruch 18,
**dadurch gekennzeichnet,**
**daß** der zweiter Träger (5) aus einer Kunststoffolie und insbesondere aus einer Polyimidfolie besteht.

20. Mikroelektronisches Bauteil gemäß einem der Ansprüche 1 bis 19,
**dadurch gekennzeichnet,**
**daß** es zwei Schalttransistoren (12) und zwei Dioden umfaßt.

21. Mikroelektronisches Bauteil nach Anspruch 20,
**dadurch gekennzeichnet,**
**daß** die Schalttransistoren (12) als Isolated-Gate-Bipolartransistoren ausgebildet sind.

22. Mikroelektronischer Baustein , welcher einen ersten Träger (2) mit einer ersten Leiterbahnebene (3) und einer Vielzahl von Halbleiterchips (4) umfaßt, welche mit der ersten Leiterbahnebene (3) kontaktiert sind,
**dadurch gekennzeichnet,**
**daß** zum Zwecke einer Kontaktierung der Halbleiterchips (4) mit einer zweiten Leiterbahnebene (6) auf den Halbleiterchips (4) elektrisch leitfähige Kugeln (8) mit einer elektrisch leitfähigen, flexiblen Klebstoffbeschichtung angebracht sind.

23. Mikroelektronischer Baustein nach Anspruch 22,
**dadurch gekennzeichnet**
**daß** er weiter auf der der Leiterbahn gegenüberliegenden Seite des ersten Trägers (2) eine Metallschicht (9) aufweist.

24. Mikroelektronischer Baustein nach Anspruch 22 oder 23,
**dadurch gekennzeichnet,**
**daß** er weiter auf der der Leiterbahn gegenüberliegenden Seite des ersten Trägers (2) eine Wärmesenke (19) aufweist.

25. Mikroelektronischer Baustein nach einem der Ansprüche 22 bis 24,
**dadurch gekennzeichnet,**
**daß** an dem ersten Träger (2) zwei oder mehr Halterungen (22) vorhanden sind, welche lösbar in zugehörige Ausnehmungen oder Durchgangsöffnungen (21) in anderen Trägern (5, 2) eingreifen.

26. Verfahren zur Herstellung eines mikroelektronischen Bauteils (1) gemäß einem der Ansprüche 2 und 4 bis 21,
**dadurch gekennzeichnet,**
**daß** es die folgenden Schritte umfaßt:
- Befestigen von elektrisch leitfähigen Kugeln (8) auf die Kontaktstellen der zweiten Leiterbahnebene (6) des zweiten Trägers (5) mit Hilfe eines elektrisch leitfähigen, flexiblen Kleber,
- Aufbringen eines elektrisch leitfähigen, flexiblen Klebers auf die Kontaktflächen der mit der ersten Leiterbahnebene (3) des ersten Trägers (2) kontaktierten Halbleiterchips (4) und
- Zusammenfügen von erstem und zweitem Träger (2, 5).

27. Wechselrichter,
**dadurch gekennzeichnet,**
**dass** er ein mikroelektronisches Bauteil gemäß einem der Ansprüche 1 bis 21 oder einen mikroelektronischen Baustein gemäß einem der Ansprüche 22 bis 25 enthält.

## Claims

1. Microelectronic component (1) of sandwich construction, which comprises a first mount (2) with a first interconnect level (3) and a multiplicity of semiconductor chips (4) which make contact with the first interconnect level (3), wherein a second mount (5) having a second interconnect level (6) is arranged on the side of the semiconductor chips (4) opposite the first mount (2) and makes firm contact with those surfaces of the semiconductor chips which face away from the first mount (2),
**characterized in that**
a contact is provided between the semiconductor chips (4) and the second interconnect level (6), which is less sensitive to thermal mechanical stresses than solder connections, and is implemented with the aid of an electrically conductive, flexible adhesive.

2. Microelectronic component according to Claim 1,
**characterized in that**
electrically conductive balls (8) are adhesively bonded to the semiconductor chips (4) and to the second interconnect level (6) with the aid of the electrically conductive adhesive.

3. Microelectronic component according to Claim 1,
**characterized in that**
electrically conductive spring elements are adhesively bonded to the semiconductor chips (4) and to the second interconnect level (6) with the aid of an electrically conductive adhesive.

4. Microelectronic component according to one of Claims 1 to 3,
**characterized in that**
at least one of the first and second mounts (2, 5) is composed of a ceramic material.

5. Microelectronic component according to Claim 4,
**characterized in that**
the ceramic material is composed of aluminium-oxide ceramic or aluminium-nitride ceramic.

6. Microelectronic component according to Claim 4 or 5,
**characterized in that**
the assembly comprising the mounts (2, 5) and the interconnect (3, 6) is in the form of a thick-film ceramic with interconnects burnt on or in, or is designed using direct copper bonding technology or active metal brazing technology.

7. Microelectronic component according to Claim 6,
**characterized in that**
the interconnects are composed of copper or silver.

8. Microelectronic component according to one of Claims 1 to 7,
**characterized in that**
a metal layer (9) is formed on that side of at least one of the first and second mounts (2, 5) which is opposite the interconnect.

9. Microelectronic component according to one of Claims 1 to 8,
**characterized in that**
a heat sink is arranged on that side of at least one of the first and second mounts (2, 5) which is opposite the interconnect.

10. Microelectronic component according to one of Claims 1 to 9,
**characterized in that**
the second mount (5) has via holes (10).

11. Microelectronic component according to one of Claims 1 to 10,
**characterized in that**
the semiconductor chips (4) are power chips.

12. Microelectronic component according to one of Claims 1 to 11,
**characterized in that**
the microelectronic component furthermore comprises at least one drive component, evaluation electronic component, and a protective component (11).

13. Microelectronic component according to Claim 12,
**characterized in that**
at least one of the drive or evaluation electronic or protective components (11) is arranged on the second mount (5).

14. Microelectronic component according to Claim 13,
**characterized in that**
the component (11) makes contact with the second interconnect level (6) through via holes (10) in the second mount (5).

15. Microelectronic component according to one of Claims 1 to 14,
**characterized in that**
the first and second mounts (2, 5) are bracketed to one another.

16. Microelectronic component according to Claim 15,
**characterized in that**
two or more holders are provided on one of the mounts (2, 5) and detachably engage in associated recesses or aperture openings in the other mount (5, 2).

17. Microelectronic component according to one of Claims 1 to 16,
**characterized in that**
the second mount (5) is broken down into a plurality of individual areas.

18. Microelectronic component according to one of Claims 1 to 17,
**characterized in that**
the second mount (5) is a flexible mount.

19. Microelectronic component according to Claim 18,
**characterized in that**
the second mount (5) is composed of a plastic film, and in particular of a polyimide film.

20. Microelectronic component according to one of Claims 1 to 19,
**characterized in that**
the microelectronic component comprises two switching transistors (12) and two diodes.

21. Microelectronic component according to Claim 20,
**characterized in that**
the switching transistors (12) are in the form of isolated gate bipolar transistors.

22. Microelectronic module which comprises a first mount (2) with a first interconnect level (3) and a multiplicity of semiconductor chips (4), which make contact with the first interconnect level (3),
**characterized in that**
electrically conductive balls (8) having an electrically conductive, flexible adhesive coating are applied to the semiconductor chips (4) in order to make contact between the semiconductor chips (4) and a second interconnect level (6).

23. Microelectronic module according to Claim 22,
**characterized in that**
the microelectronic module furthermore has a metal layer (9) on the side of the first mount (2) opposite the interconnect.

24. Microelectronic module according to Claim 22 or 23,
**characterized in that**
the microelectronic module furthermore has a heat sink (19) on the side of the first mount (2) opposite the interconnect.

25. Microelectronic module according to one of Claims 22 to 24,
**characterized in that**
two or more holders (22) are provided on the first mount (2) and detachably engage in associated recesses or aperture openings (21) in other mounts (5, 2).

26. Method for the production of a microelectronic component (1) according to one of Claims 2 and 4 to 21,
**characterized in that**
the method comprises the following steps:
- attachment of electrically conductive balls (8) to the contact points on the second interconnect level (6) of the second mount (5), with the aid of an electrically conductive, flexible adhesive,
- application of an electrically conductive, flexible adhesive to the contact surfaces of the semiconductor chips (4) which make contact with the first interconnect level (3) of the first mount (2), and
- joining of the first and second mounts (2, 5).

27. Inverter,
**characterized in that**
the inverter contains a microelectronic component according to one of Claims 1 to 21, or a microelectronic module according to one of Claims 22 to 25.

## Revendications

1. Composant (1) microélectronique en structure sandwich, qui comprend un premier support (2) ayant un premier plan (3) de pistes conductrices et une pluralité de puces (4) à semiconducteurs, qui sont mises en contact avec le premier plan (3) de pistes conductrices, dans lequel, sur la face des puces (4) à semiconducteurs opposée au premier support (2), est disposé un deuxième support (5) ayant un deuxième plan de pistes conductrices, qui est mis en contact fixe avec les surfaces des puces (4) à semiconducteurs éloignées du premier support (2),
**caractérisé**
**en ce qu'**il est prévu une mise en contact des puces à semiconducteurs avec le deuxième plan (6) de pistes conductrices, qui est plus insensible aux tensions thermomécaniques que des joints brasés et qui est réalisée à l'aide d'une colle souple et conductrice de l'électricité.

2. Composant microélectronique suivant la revendication 1,
**caractérisé**
**en ce que** des billes (8) conductrices de l'électricité sont collées aux puces (4) à semiconducteurs et le deuxième plan (6) de pistes conductrices est collé à l'aide de la colle conductrice de l'électricité.

3. Composant microélectronique suivant la revendication 1,
**caractérisé**
**en ce que** des éléments à ressort conducteurs de l'électricité sont collés aux puces (4) à semiconducteurs et le deuxième plan (6) de pistes conductrices est collé à l'aide d'une colle conductrice de l'électricité.

4. Composant microélectronique suivant l'une des revendications 1 à 3,
**caractérisé**
**en ce qu'**au moins l'un des premier et deuxième supports (2, 5) est en un matériau céramique.

5. Composant microélectronique suivant la revendication 4,
**caractérisé**
**en ce que** le matériau céramique est une céramique en oxyde d'aluminium ou en nitrure d'aluminium.

6. Composant microélectronique suivant la revendication 4 ou 5,
**caractérisé**
**en ce que** le composite de supports (2, 5) et de pistes (3, 6) conductrices est réalisé sous la forme d'une céramique en couche épaisse ayant des pistes conductrices appliquées ou incorporées par cuisson ou réalisées suivant la technique direct-copper-bonding ou suivant la technique active-metal-brazing.

7. Composant microélectronique suivant la revendication 6,
**caractérisé**
**en ce que** les pistes conductrices sont en cuivre ou en argent.

8. Composant microélectronique suivant l'une des revendications 1 à 7,
**caractérisé**
**en ce qu'**une couche (9) métallique est formée sur la face d'au moins l'un des premier et deuxième supports (2, 5) opposée à la piste conductrice.

9. Composant microélectronique suivant l'une des revendications 1 à 8,
**caractérisé**
**en ce qu'**un puits de chaleur est disposé sur la face d'au moins l'un des premier et deuxième supports (2, 5) opposée à la piste conductrice.

10. Composant microélectronique suivant l'une des revendications 1 à 9,
**caractérisé**
**en ce que** le deuxième support (5) a des trous (10) de traversée.

11. Composant microélectronique suivant l'une des revendications 1 à 10,
**caractérisé**
**en ce que** les puces (4) à semiconducteurs sont des puces de puissance.

12. Composant microélectronique suivant l'une des revendications 1 à 11,
**caractérisé**
**en ce qu'**il comprend, en outre, au moins un composant de commande, un composant d'électronique d'exploitation, un composant (11) de protection.

13. Composant microélectronique suivant la revendication 12,
**caractérisé**
**en ce qu'**au moins l'un des composants de commande ou d'électronique d'exploitation ou de protection est disposé sur le deuxième support (5).

14. Composant microélectronique suivant la revendication 13,
**caractérisé**
**en ce que** le composant (11) est mis en contact avec le deuxième plan (6) de pistes conductrices par des trous (10) de traversée dans le deuxième support (5).

15. Composant microélectronique suivant l'une des revendications 1 à 14,
**caractérisé**
**en ce que** le premier et le deuxième supports (2, 5) sont cramponnés ensemble.

16. Composant microélectronique suivant la revendication 15,
**caractérisé**
**en ce qu'**il y a sur l'un des supports (2, 5) deux ou plusieurs fixations, qui pénètrent de manière amovible dans des évidements associés ou des ouvertures de traversée de l'autre support (5, 2).

17. Composant microélectronique suivant l'une des revendications 1 à 16,
**caractérisé**
**en ce que** le deuxième support (5) est séparé en plusieurs parties individuelles.

18. Composant microélectronique suivant l'une des revendication 1 à 17,
**caractérisé**
**en ce que** le deuxième support (5) est un support souple.

19. Composant microélectronique suivant la revendication 18,
**caractérisé**
**en ce que** le deuxième support (5) est en une feuille de matière plastique, et notamment en une feuille de polyimide.

20. Composant microélectronique suivant l'une des revendications 1 à 19,
**caractérisé**
**en ce qu'**il comprend deux transistors (12) de commutation et deux diodes.

21. Composant microélectronique suivant la revendication 20,
**caractérisé**
**en ce que** les transistors (12) de commutation sont constitués sous la forme de transistors bipolaires à grille isolée.

22. Module microélectronique, qui comprend un premier support (2) ayant un premier plan (3) de pistes conductrices et une pluralité de puces (4) à semiconducteurs, qui sont mises en contact avec le premier plan (3) de pistes conductrices,
**caractérisé**
**en ce que**, en vue d'une mise en contact des puces (4) à semiconducteurs avec un deuxième plan (6) de pistes conductrices, il est appliqué sur les puces (4) à semiconducteurs des billes (8) conductrices de l'électricité ayant un revêtement de colle souple et conductrice de l'électricité.

23. Module microélectronique suivant la revendication 22,
**caractérisé**
**en ce qu'**il a, en outre, une couche (9) métallique sur la face du premier support (2) opposée à la piste conductrice.

24. Module microélectronique suivant la revendication 22 ou 23,
**caractérisé**
**en ce qu'**il a un puits (19) de chaleur sur la face du premier support (2) opposée à la piste conductrice.

25. Module microélectronique suivant l'une des revendications 22 à 24,
**caractérisé**
**en ce qu'**il y a sur le premier support (2) deux ou plusieurs fixations (22), qui pénètrent de manière amovible dans des évidements associés ou dans des ouvertures (21) de traversée d'autres supports (5, 2).

26. Procédé de fabrication d'un composant (1) microélectronique suivant l'une des revendications 2 et 4 à 21,
**caractérisé**
**en ce qu'**il comprend les stades suivants :
- on fixe des billes (8) conductrices de l'électricité sur les points de contact du deuxième plan (6) de pistes conductrices du deuxième support à l'aide d'une colle souple et conductrice de l'électricité,
- on applique une colle souple et conductrice de l'électricité sur la surface de contact des puces (4) à semiconducteurs mises en contact avec le premier plan (3) de pistes conductrices du premier support (2) et
- on assemble le premier et le deuxième supports (2, 5).

27. Onduleur,
**caractérisé**
**en ce qu'**il comporte un composant microélectronique suivant l'une des revendications 1 à 21 ou un module microélectronique suivant l'une des revendications 22 à 25.
